# EUROPÄISCHE PATENTANMELDUNG

(11) **EP 0 986 111 A2**
(43) Veröffentlichungstag der Anmeldung: **15.03.2000**
(21) Anmeldenummer: 99115284.4
(22) Anmeldetag: 02.08.1999
(51) Int. Cl.: H01L 43/14

(54) **Verfahren zum Herstellen eines Elektronikbauelementes, insbesondere eines Hallsensors**

(30) Priorität: 10.09.1998 DE 19841498
(71) Anmelder: Beru AG, 71636 Ludwigsburg (DE)
(72) Erfinder: Baeskow, Werner, 74394 Hessigheim (DE)
(74) Vertreter: WILHELMS, KILIAN & PARTNER Patentanwälte

(57) **Zusammenfassung**

Verfahren zum Herstellen eines Elektronikbauelementes, das elektronische Bauteile (4) aufweist, die in einem Kunststoffgehäuse angeordnet sind, insbesondere eines Hallsensors. Zur Zeit- und Kostenersparnis des Herstellungsverfahrens werden die elektronischen Bauteile in einer Schmelzklebermasse angeordnet und dort fixiert und danach zur Ausbildung des Gehäuses (8) fertigumspritzt.

## Beschreibung

Die Erfindung betrifft ein Verfahren zum Herstellen eines Elektronikbauelementes, das elektronische Bauteile aufweist, die in einem Kunststoffgehäuse angeordnet sind, insbesondere eines Hallsensors.

Elektronikbauelemente werden bisher dadurch hergestellt, das ihre elektronisches Bauteile in einem Kunststoffgehäuse vergossen oder dicht eingebettet werden, da ein direktes Umspritzen elektronischer Bauteile aufgrund der thermischen Beanspruchungen beim Umspritzvorgang und aufgrund einer möglichen Schädigung durch die dabei auftretende Druckbelastung der elektronischen Bauteile nicht möglich ist. Das heißt, daß eine Endumspritzung beispielsweise mit Thermo- oder Duroplasten die elektronischen Bauteile zerstören und bei zu hohem Druck und zu hoher Temperaturen schädigen kann. Vergüsse mit PU- bzw. Epoxidharzen sind andererseits nach dem Aushärten hart und unflexibel.

Um die elektronischen Bauteile vor den schädigenden Einflüssen eines zu hohen Druckes oder einer zu hohen Temperatur zu bewahren, müssen sie mit einem zusätzlichen Deckel bzw. einer Kappe oder durch eine Vergußmasse aufwendig geschützt werden, um die Spritzmasse fern zu halten. Das hat zur Folge, daß zusätzliche Bauteile wie Gehäuse, Deckel u.s.w. eingesetzt werden müssen.

Das Vergießen von elektronischen Bauteilen, beispielsweise mit einem PU Verguß, erfordert darüberhinaus in der Serienfertigung eine hohe Taktzeit für das Aushärten.

Weitere Probleme bei dem üblichen Herstellungsverfahren sind in der mangelnden Fixierung des Schutzdeckels oder der Schutzkappe, der Bildung von Hohlräumen mit Lufteinschlüssen, der Probleme mit verschiedenen Wärmeausdehnungskoeffizienten der Materialien bei der Einbettung mit harten Vergußmassen und in der Rißgefahr der Bauteile bei Temperaturwechseln zu sehen.

Diese Schwierigkeiten machen sich bei den bisher üblichen Herstellungsverfahren in einem hohen Zeit- und Kostenaufwand bemerkbar.

Die der Erfindung zugrunde liegende Aufgabe besteht daher darin, ein Verfahren zum Herstellen eines Elektronikbauelements der eingangs genannten Art anzugeben, das zeit- und kostensparend ausgebildet ist.

Diese Aufgabe wird gemäß der Erfindung dadurch gelöst, daß die elektronischen Bauteile in einer Schmelzklebermasse angeordnet und danach zur Ausbildung des Gehäuses fertigumspritzt werden.

Bei dem erfindungsgemäßen Verfahren ist ein sicheres Einbetten und Festlegen der elektronischen Bauteile in der Schmelzklebermasse derart möglich, daß anschließend das Gehäuse mit einem üblichen Umspritzverfahren ausgebildet werden kann und das Elektronikbauelement dadurch seine endgültige Form bekommt.

Vorzugsweise werden die elektronischen Bauteile in der Schmelzklebermasse eingebettet oder mit der Schmelzklebermasse umspritzt.

Wenn insbesondere für den Träger der elektronischen Bauteile, den Schmelzkleber und das Gehäuse gleichartige Werkstoffe verwandt werden, ist es möglich, die Wärmeausdehnungskoeffizienten dieser Materialien soweit anzugleichen, das keine Probleme in dieser Hinsicht auftreten.

Vorzugsweise sind diese Materialien Polyamidwerkstoffe.

Im folgenden wird anhand der zugehörigen Zeichnung ein besonders bevorzugtes Ausführungsbeispiel des erfindungsgemäßen Verfahrens näher beschrieben. Es zeigen
Fig. 1a und 1b Schnittansichten eines Hallsensors, der nach dem erfindungsgemäßen Verfahren hergestellt wurde,
Fig. 2a und 2b Schnittansichten des in Fig. 1a und 1b dargestellten Hallsensors mit Endumspritzung und
Fig. 3a und 3b Schnittansichten von Hallsensoren, die nach dem herkömmlichen Verfahren hergestellt wurden.

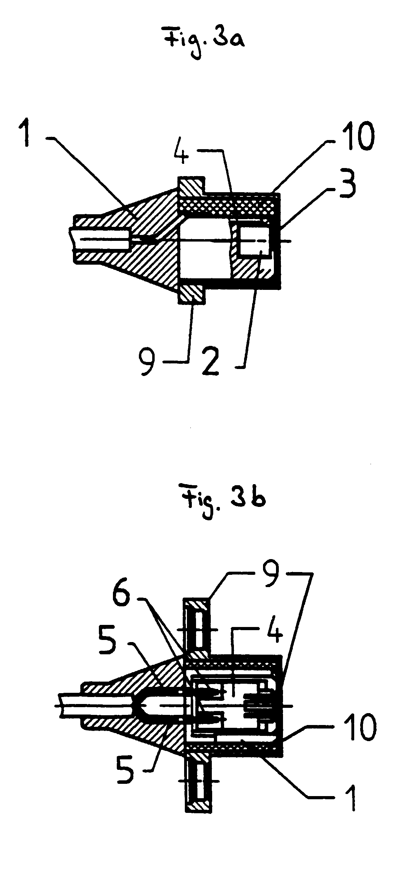

Wie es in den Fig. 3a und 3b dargestellt ist, besteht ein Hallsensor im wesentlichen aus einem Träger 1, einem Magneten 2, einem Hall-IC 3, eine Platine 4, einer Anschlußleitung 5 mit Lötstelle 6, einem Gehäuse 9 und einem Gießharz 10.

Der Träger 1 mit dem Magneten 2, der Hall-IC 3 und die mit elektronischen Bautelementen besetzte Platine 4 werden bei einem üblichen Herstellungsverfahren als Einheit samt gelöteter Leitung 5 im Gehäuse 9 angeordnet und dann mit dem Harz 10 vergossen. Danach erfolgt eine Endumspritzung.

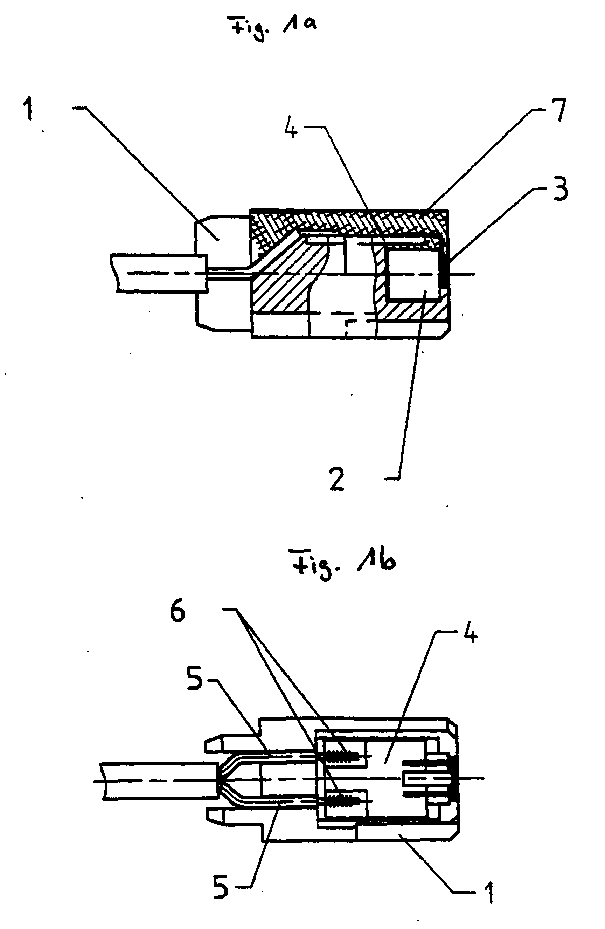

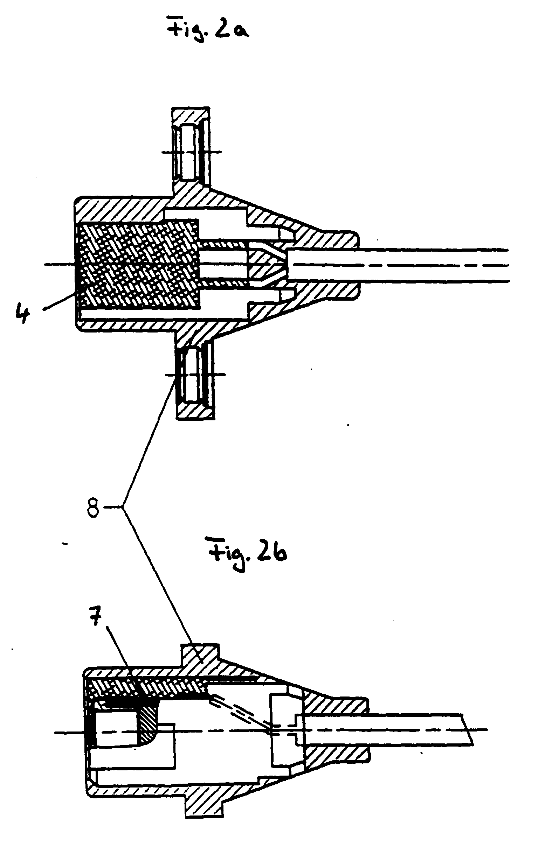

Wie es in den Figuren 1a, 1b und 2a und 2b dargestellt ist, wird demgegenüber bei dem erfindungsgemäßen Verfahren ein im Hochdruckverfahren gespritzter Träger 1 mit einem Magneten 2, einem Hall-IC 3 und einer mit elektronischen Bauelementen besetzten Platine 4 bestückt. Diese Baueinheit wird samt angelöteter Leitung 5 mit Lötstelle 6 in einer Werkzeugform im Niederdruckverfahren mit einem Schmelzkleber beispielsweise einem copolymeren Polyamid 7 umspritzt. Dabei wird der Schmelzkleber 7 mit einer Temperatur von 180°C bis 220°C und einem Druck von 2 bis 10 bar in die Werkzeugform gespritzt. Er härtet innerhalb weniger Sekunden aus. Durch diesen Arbeitsvorgang werden sowohl die Platine 4 als auch alle übrigen Bauteile nämlich der Magnet 2, der Hall-IC 3 und die Lötstelle 6 in den Schmelzkleber eingebettet und darin fixiert.

Nach dem Fixieren der elektronischen Bauelemente im Schmelzkleber erfolgt eine Endumspritzung 8, die in Fig. 2a und 2b dargestellt ist, und zwar mit einer beliebigen Außengeometrie, beispielsweise aus Polyamid oder aus Duroplastwerkstoffen, im Hochdruckverfahren.

Bei dem erfindungsgemäßen Verfahren kann das Anordnen der empfindlichen elektronischen Bauteile wie beispielsweise der Sensorplatine nicht nur durch Umspritzen im Niederdruckverfahren sondern auch durch Einbetten im Schmelzkleber erfolgen. Danach erfolgt die Fertigumspritzung, nachdem die empfindlichen elektronischen Bauteile in dieser Weise mit dem Schmelzkleber fixiert worden sind.

Wenn gleichartige Werkstoffe für den Träger der Platine, das Fixierungsmaterial d.h. den Schmelzkleber und die Umspritzung verwandt werden, die ähnliche Wärmeausdehnungskoeffizienten hahen, können unterschiedliche Wärmeausdehnungen vermieden werden.

Die Fixierung der elektronischen Bauteile in einem Schmelzkleber hat darüber hinaus den Vorteil, daß dieser Werkstoff im Schadensfall für Diagnosezwecke oder zum Recycling wieder rückstandsfrei von der Platine entfernt werden kann.

Das erfindungsgemäße Verfahren ist weniger kosten- und zeitaufwendig als das Vergießen mit PU- bzw. Epoxidharzen, bei dem ein späterer Aushärtevorgang in einem Ofen oder unter Vacuum notwendig ist. Die Anordnung von Schutzdeckeln oder -kappen oder einem Gehäuse zum Schutz der elektronischen Bauteile erübrigt sich.

Demgegenüber wird durch das erfindungsgemäße Verfahren eine sichere Einbettung und Fixierung aller Bauteile erzielt, werden zu hohe Druckbelastungen oder Temperaturbelastungen der elektronischen Bauteile bei der Endumspritzung vermieden, die zu einer Vorschädigung oder Zerstörung der elektronischen Bauteile führen könnten, und wird ein Abriss von Bauteilen aufgrund unterschiedlicher Wärmeausdehnungskoeffizienten ihrer Materialien bei Temperaturwechseln vermieden.

Es sind keine Lufteinschlüsse zu befürchten, die Schmelzklebereinbettung kann sicher gehandhabt werden, ein Aufschmelzen der Lötstellen beim der Endumspritzung bei hohen Drücken bzw. Temperaturen ist darüber hinaus ausgeschlossen.

## Patentansprüche

1. Verfahren zum Herstellen eines Elektronikbauelementes das elektronische Bauteile aufweist, die in einem Kunststoffgehäuse angeordnet sind, insbesondere eines Hallsensors dadurch gekennzeichnet, daß die elektronischen Bauteile (2, 3, 4) in einer Schmelzklebermasse (7) angeordnet und danach zur Ausbildung des Kunststoffgehäuses (8) fertigumspritzt werden.

2. Verfahren nach Anspruch 1, dadurch gekennzeichnet, daß die elektronischen Bauteile (2, 3, 4) in die Schmelzklebermasse (7) eingebettet werden.

3. Verfahren nach Anspruch 1, dadurch gekennzeichnet, daß die elektronischen Bauteile (2, 3, 4) mit der Schmelzklebermasse (7) umspritzt werden.

4. Verfahren nach einem der vorhergehenden Ansprüche, dadurch gekennzeichnet, daß für den Träger der elektronischen Bauteile (2, 3, 4), die Schmelzklebermasse (7) und das Material der Umspritzung (8) gleichartige Werkstoffe verwandt werden.

5. Verfahren nach Anspruch 4, dadurch gekennzeichnet, daß die Werkstoffe Polyamide sind.
